**Europäisches Patentamt**

(19) **European Patent Office**

**Office européen des brevets**

(11) Veröffentlichungsnummer: **0 065 671**
**B1**

(12) **EUROPÄISCHE PATENTSCHRIFT**

(45) Veröffentlichungstag der Patentschrift:
**16.09.87**

(51) Int. Cl.⁴: **H 01 L 29/743,** H 01 L 29/52,
H 01 L 29/08

(21) Anmeldenummer: **82103783.5**

(22) Anmeldetag: **03.05.82**

(54) **Thyristor mit Hilfsemitterelektrode und Kurzschlussgebieten sowie Verfahren zu seinem Betrieb.**

(30) Priorität: **08.05.81 DE 3118317**

(43) Veröffentlichungstag der Anmeldung:
**01.12.82 Patentblatt 82/48**

(45) Bekanntmachung des Hinweises auf die Patenterteilung:
**16.09.87 Patentblatt 87/38**

(84) Benannte Vertragsstaaten:
**CH FR GB IT LI SE**

(56) Entgegenhaltungen:
**EP - A - 0 008 008**
**EP - A - 0 028 798**
**DE - A - 1 211 334**
**DE - A - 2 163 922**
**DE - A - 2 625 917**

(73) Patentinhaber: **Siemens Aktiengesellschaft Berlin und München, Wittelsbacherplatz 2, D-8000 München 2 (DE)**

(72) Erfinder: **Stoisiek, Michael, Dr., Robert-Koch-Strasse 24, D-8012 Ottobrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf einen Thyristor nach dem Oberbegriff des Patentanspruchs 1.

Ein solcher Thyristor ist aus der DE-A-26 25 917 bekannt. Er weist als MIS-Strukturen ausgebildete, abschaltbare Strompfade auf, die zum Zwecke eines schnellen Löschens des Thyristors wirksam geschaltet werden. Zu einem solchen abschaltbaren Strompfad gehört neben dem ersten Halbleitergebiet ein zweites Halbleitergebiet des ersten Leitungstyps, das aus einem Randbereich des n-oder p-Emitters besteht, sowie ein zwischen dem ersten und dem zweiten Halbleitergebiet liegender, einen zweiten Leitungstyp aufweisender Teilbereich der an diesen Emitter angrenzenden Basisschicht, der von einem isolierten Gate überdeckt ist. Hieraus ist es auch bekannt, die Strompfade während des Auftretens eines Zündimpulses wirksam zu schalten, um eine Zündung zu verhindern. Einem Hilfsemitter zugeordnete Strompfade, die vor dem Zünden des Thyristors wirksam geschaltet sind, um diesen zu stabilisieren, während sie beim Zündvorgang abgeschaltet sind, lassen sich hieraus jedoch nicht entnehmen.

Auch der DE-A-1 211 334, vgl. insbesondere Fig. 9, ist ein Thyristor nach dem Oberbegriff des Patentanspruchs 1 entnehmbar, dessen als MIS-Strukturen ausgebildete, abschaltbare Strompfade lediglich zum Zwecke eines schnellen Löschens des Thyristors wirksam geschaltet werden. Hierbei besteht das zweite Halbleitergebiet einer der MIS-Strukturen aus einem Randbereich des p-Emitters. Ein Hilfsemitter ist bei diesem Thyristor nicht vorgesehen.

Die EP-A-0 008 008 zeigt einen Thyristor mit einem als MIS-Struktur ausgebildeten abschaltbaren Strompfad, der zwischen dem n-Emitter und der n-Basisschicht verläuft. Zu diesem Zweck ist in die p-Basisschicht eine n-leitende Halbleiterzone eingefügt, die sich von der den n-Emitter enthaltenden Oberfläche des Thyristors bis zu der n-Basisschicht hin erstreckt. Diese Halbleiterzone stellt ein erstes n-Halbleitergebiet der MIS-Struktur dar, während eine Randzone des n-Emitters das zweite n-Halbleitergebiet bildet. Der Halblei-terbereich zwischen diesen beiden Halbleiterge-bieten, der aus einem Teilbereich der p-Basisschicht besteht, wird von einem gegenüber dem Körper des Thyristors elektrisch isolierten, mit einem Steueranschluss versehenen Gate überdeckt.

In der EP-A-0 028 798, die gemäss Artikel 54(3) zum Stand der Technik gehört, ist ein Thyristor beschrieben, der zum Zwecke einer inneren Zündverstärkung mit einem Hilfsemitter und einer Hilfsemitterelektrode (amplifying gate) ausgestattet ist. Seine Stabilität, d.h. seine Sicherheit gegenüber unbeabsichtigten Zündvorgängen beim Auftreten von grossen, in Durchlassrichtung gepolten Spannungen an der Anoden-Kathoden-Strecke, wird durch wenigstens einen als MIS-Struktur ausgebildeten, abschaltbaren Strompfad gewährleistet, der den Hilfsemitter niederohmig mit der an diesen angrenzenden Basisschicht verbindet. Die MIS-Struktur besitzt einen Steueranschluss, dem ein Spannungsimpuls zugeführt wird, der den Strompfad für die Dauer des Zündvorgangs abschaltet.

Der vorliegenden Erfindung liegt die Aufgabe zugrunde, einen in einfacher Weise herstellbaren Thyristor der eingangs genannten Art anzugeben, der mit einem Hilfsemitter versehen ist, wobei einerseits eine grosse Stabilität gegenüber unbeabsichtigten Zündvorgängen als auch ein hierdurch nicht beeinträchtigtes Einschaltverhalten angestrebt wird. Das wird erfindungsgemäss durch eine Ausbildung nach dem kennzeichnenden Teil des Patentanspruchs 1 erreicht.

Der mit der Erfindung erzielbare Vorteil besteht insbesondere darin, dass die Herstellung der für den abschaltbaren Strompfad erforderlichen Kurzschlussgebiete im Rahmen derjenigen Dotierungsschritte erfolgt, die bereits zur Herstellung der einzelnen Halbleitergebiete bzw. -schichten des Thyristors benötigt werden, so dass der Mehraufwand für den abschaltbaren Strompfad sehr klein gehalten werden kann.

Die Ansprüche 2 bis 5 betreffen Weiterbildung des Thyristors nach der Erfindung.

Nachfolgend wird die Erfindung anhand der Zeichnung näher erläutert. Dabei zeigen:

Fig. 1 ein erstes Ausführungsbeispiel der Erfindung,

Fig. 2 und Fig. 3 Spannungs-Zeit-Diagramme zur Erläuterung von Fig. 1,

Fig. 4 eine Teilschaltung von Fig. 1,

Fig. 5 eine alternative Schaltung zu Fig. 4 und

Fig. 6 ein zweites Ausführungsbeispiel.

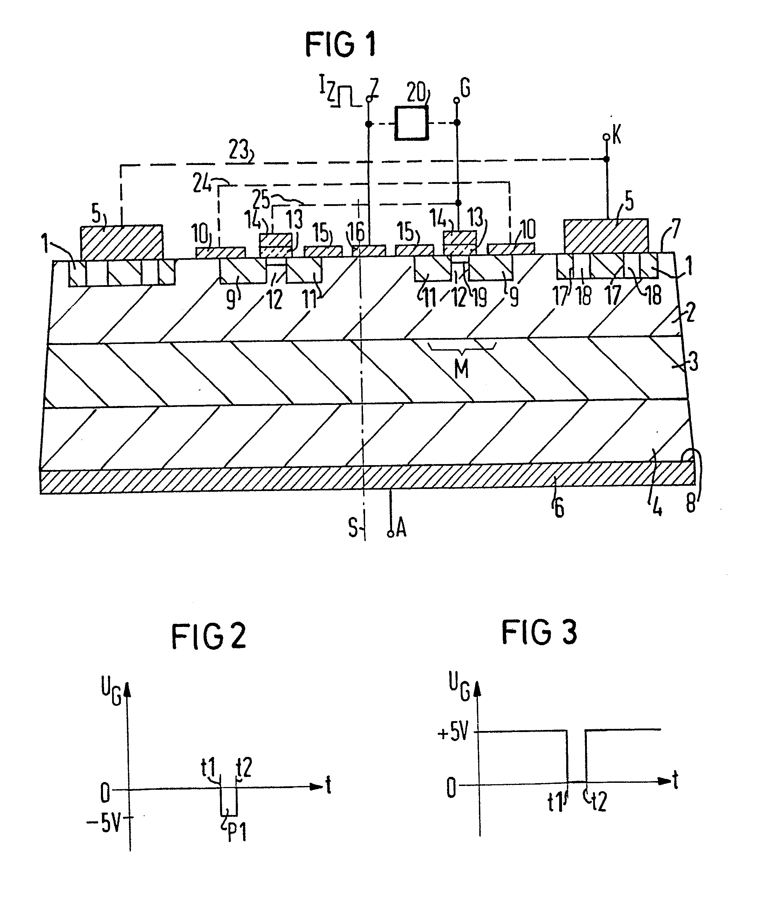

Der in Fig. 1 dargestellte Thyristor weist einen zu einer Achse S rotationssymmetrischen Halbleiterkörper aus dotiertem Halbleitermaterial, z.B. Silizium, mit vier aufeinanderfolgenden Schichten abwechselnder Leitungstypen auf. Dabei bezeichnet man eine n-leitende Schicht 1 als den n-Emitter, eine p-leitende Schicht 2 als die p-Basisschicht, eine n-leitende Schicht 3 als die n-Basisschicht und eine p-leitende Schicht 4 als den p-Emitter. Der n-Emitter 1 ist an der Grenzfläche 7 des Halbleiterkörpers mit einer Kathode 5 aus elektrisch leitendem Material, z.B. Aluminium, versehen, die ebenso wie der n-Emitter kreisringförmig ausgebildet ist. Der p-Emitter 4 ist an der gegenüberliegenden Grenzfläche 8 des Halbleiterkörpers mit einer Anode 6 aus elektrisch leitendem Material, z.B. Aluminium, belegt. Die Kathode 5 ist mit einem Anschluss K verbunden, während die Anode 6 mit einem Anschluss A versehen ist.

In die p-Basisschicht 2 ist ein mit 9 bezeichne-tes, kreisringförmiges, n-leitendes Halbleiterge-biet eingefügt, das sich bis zur Grenzfläche 7 erstreckt. Es wird als Hilfsemittergebiet bezeichnet. In der Grenzfläche 7 wird es von einer kreisringförmigen Hilfsemitterelektrode 10 aus elektrisch leitendem Material kontaktiert, die in Richtung auf den n-Emitter 1 soweit verlängert ist, dass sie den pn-Übergang am äusseren Rand des Hilfsemittergebiets 9 gegenüber der p-Basisschicht 2 niederohmig überbrückt.

In die p-Basisschicht 2 ist ein ebenfalls ringförmiges, n-leitendes Kurzschlussgebiet 11 eingefügt, das sich bis zur Grenzfläche 7 erstreckt. Es ist konzentrisch zu dem Hilfsemittergebiet 9 angeordnet und weist von diesem in radialer Richtung einen Abstand auf, der durch die Breite eines Teilbereichs 12 der p-Basisschicht 2 bestimmt ist. Dieser Teilbereich 12 wird von einer auf der Grenzfläche 7 angeordneten, dünnen, elektrisch isolierenden Schicht 13 überdeckt, auf der ein Gate 14 angeordnet ist, das mit einem Steueranschluss G verbunden ist. Das Gate 14 besteht dabei aus elektrisch leitendem Material, z.B. aus hochdotiertem polykristallinen Silizium oder aus Metall, insbesondere Aluminium. Das Kurzschlussgebiet 11 wird an seinem von dem Hilfsemittergebiet 9 abgewandten Rand von einer leitenden Belegung 15 kontaktiert, die so weit in Richtung der Symmetrieachse S verlängert ist, dass der pn-Übergang zwischen den Teilen 11 und 2 an dieser Stelle niederohmig überbrückt wird. Ein zentraler Teil der p-Basisschicht 2 ist mit einer Zündelektrode 16 belegt, die mit einem Anschluss Z für einen Zündstromkreis verbunden ist.

Der n-Emitter 1 weist Ausnehmungen 17 auf, die von Ansätzen 18 der p-Basisschicht 2 ausgefüllt sind. Diese Ansätze 18 erstrecken sich bis zur Grenzfläche 7 des Halbleiterkörpers und werden in dieser von der Kathode 5 kontaktiert.

Der innere Randbereich des Hilfsemittergebietes 9 stellt ein erstes n-leitendes Halbleitergebiet und das Kurzschlussgebiet 11 ein zweites n-leitendes Halbleitergebiet einer MIS-Struktur M dar, zu der weiterhin der p-leitende Teilbereich 12, die isolierende Schicht 13 und das Gate 14 gehören. Handelt es sich um eine MIS-Struktur des Verarmungstyps, so ist bei spannungslosem Gate 14 ein n-leitender Kanal 19 unterhalb des Gate 14 an der Grenzfläche 7 vorhanden, der die Halbleitergebiete 9 und 11 niederohmig miteinander verbindet. Im einzelnen besteht der Kanal 19 entweder aus einer Inversionsschicht, die sich unter dem Einfluss eines an der Grenzfläche 7 bestehenden elektrischen Feldes ausgebildet hat, oder aus einem n-leitenden Kanalgebiet, das durch eine zusätzliche n-Dotierung in den Teilbereich 12 unmittelbar an der Grenzfläche 7 eingebracht ist. Vom Hilfsemittergebiet 9 verläuft ein Strompfad über den Kanal 19, das Kurzschlussgebiet 11 und die leitende Belegung 15 zur p-Basisschicht 2. Bei Zuführung einer negativen Spannung an den Steueranschluss G wird der Kanal 19 aufgehoben bzw. hochohmig geschaltet und der vorstehend beschriebene Strompfad somit unterbrochen.

Vor dem Zünden des Thyristors ist der Kanal 19 wirksam geschaltet. Liegt dabei eine Blockierspannung an den Anschlüssen A und K, so werden in den Basisschichten thermisch generierte Defektelektronen, die sich unter dem Einfluss dieser Spannung in Richtung auf das Hilfsemittergebiet 9 und den n-Emitter 1 bewegen, zum grössten Teil nicht die pn-Übergänge an den Grenzflächen dieser Gebiete erreichen, sondern über den beschriebenen Strompfad 15, 11 und 19 in das Gebiet 9 und über die Ansätze 18 zur Kathode 5 abgeleitet. Als Folge davon wird eine Elektronenemission aus den Gebieten 9 und 1 in die Basisschichten, die eine unerwünschte Zündung des Thyristors einleiten könnte, vermieden. Der Thyristor ist also wegen des wirksam geschalteten Strompfades 15, 11 und 19 zündunempfindlich bzw. stabil.

Die Zündung des Thyristors erfolgt durch einen dem Anschluss Z zugeführten Zündstromimpuls $I_z$. Gleichzeitig erfolgt über den Steueranschluss G eine Steuerung seiner Zündempfindlichkeit, die anhand von Fig. 2 erläutert wird. In Fig. 2 ist über der Zeit t eine dem Steueranschluss G zugeführte Steuerspannung $U_G$ aufgetragen. Zum Zündzeitpunkt t1 wird G mit einem negativen Impuls P1 von z.B. –5 Volt beaufschlagt, der eine Abschaltung des Kanals 19 bewirkt. Die über die Zündelektrode 16 in die p-Basisschicht 2 injizierten Defektelektronen bewirken dann eine Elektronenemission aus dem Hilfsemittergebiet 9 in die Basisschichten 2 und 3, durch die eine Zündung des Thyristors im Bereich des Hilfsemitters 9 eingeleitet wird. Der zunächst durch 9 fliessende Thyristorstrom wird über die Hilfsemitterelektrode 10 in Richtung auf den n-Emitter 1 abgelenkt und bewirkt im Bereich des letzteren eine schnelle und grossflächige Zündung. Nimmt man an, dass zum Zeitpunkt t2 der Thyristor im Bereich des n-Emitters 1 gezündet hat, kann zu diesem Zeitpunkt der Impuls P1 von G abgeschaltet werden. Im Bereich des Hilfsemittergebietes 9 wird der Thyristor wieder gelöscht, wobei der gesamte Laststrom durch den Teil des Thyristorquerschnittes aufgenommen wird, der den n-Emitter 1 enthält. Eine Löschung des Thyristors im Bereich des n-Emitters 1 erfolgt dann, wenn der durch A und K fliessende Laststrom einen Haltewert unterschreitet. Dies ist der Fall, wenn die an A und K anliegende, in Durchlassrichtung gepolte Spannung abgeschaltet wird oder, wenn es sich um eine Wechselspannung handelt, beim nächsten Nulldurchgang derselben.

Nach einer Schaltungsvariante kann die MIS-Struktur M auch als solche des Anreicherungstyps ausgebildet werden. In diesem Fall muss dem Steueranschluss G eine positive Spannung zugeführt werden, um einen Inversionskanal 19 zu erzeugen und aufrecht zu erhalten. Wird diese Spannung dann unterbrochen, so wird der Kanal 19 beseitigt. Die vorstehend beschriebene Stabilisierungswirkung durch den Strompfad 15, 11 und 19, die lediglich im Zeitintervall t1 bis t2 aufgehoben wird, kann hierbei durch eine Ansteuerung von G gemäss Fig. 3 erzielt werden. Dabei wird eine Steuerspannung $U_G$ von z.B. +5 Volt zugeführt, die im Zeitintervall t1 bis t2 unterbrochen wird.

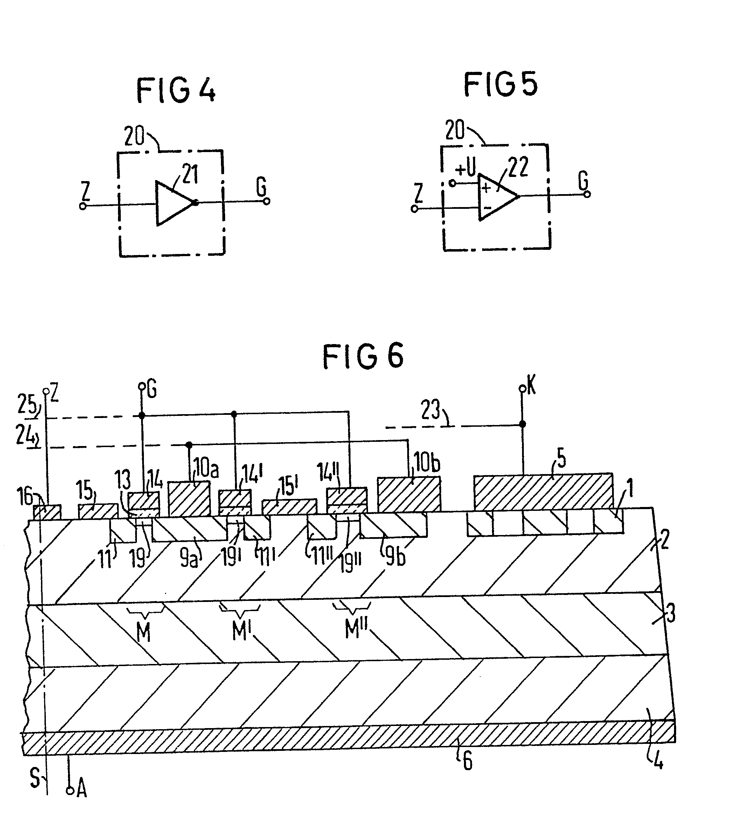

Nach einer Weiterbildung der Erfindung können die Steuerspannungen $U_G$ gemäss den Figuren 2 oder 3 durch eine Zusatzschaltung 20, die eingangsseitig mit Z und ausgangsseitig mit G beschaltet ist, aus der beim Auftreten eines Zündstromimpulses $I_z$ an dem Anschluss Z auftretenden Zündspannung abgeleitet werden. Bei einer Ansteuerung nach Fig. 2 ist die Zusatzschaltung 20 gemäss Fig. 4 als eine Polaritätsumkehrschaltung, z.B. ein invertierender Verstärker 21, ausgebildet, während bei einer Ansteuerung gemäss

Fig. 3 eine Polaritätsumkehrschaltung mit Pegelverschiebung gemäss Fig. 5 verwendet wird. Diese besteht aus einem Differenzverstärker 22, dessen positiver Eingang mit einer Spannung +U beschaltet ist, die der Grösse der an Z auftretenden Zündspannung entspricht, während der negative Eingang mit Z und der Ausgang mit G beschaltet sind.

Fig. 6 zeigt ein zweites Ausführungsbeispiel der Erfindung, das sich von Fig. 1 dadurch unterscheidet, dass dem Hilfsemittergebiet eine Mehrzahl von abschaltbaren Strompfaden zugeordnet sind. Zu diesem Zweck sind zwei Hilfsemitterteilgebiete 9a und 9b vorgesehen, die jeweils von Teilen 10a und 10b der Hilfsemitterelektrode kontaktiert sind. Das Teil 10a ragt dabei nicht über den Rand des Teilgebietes 9a hinaus, während das Teil 10b den Rand von 9b in Richtung auf den n-Emitter 1 überragt, so dass der pn-Übergang zwischen den Teilen 9b und 2 an dieser Stelle niederohmig überbrückt wird. An dem linksseitigen Rand von 9a ist die bereits anhand von Fig. 1 beschriebene MIS-Struktur M angeordnet, deren Teile mit den gleichen Bezugszeichen wie in Fig. 1 bezeichnet sind. An dem rechten Rand von 9a befindet sich eine entsprechende MIS-Struktur M' und an dem linken Rand von 9b eine weitere Struktur derselben Art, die mit M'' bezeichnet ist. Die zu diesen Strukturen gehörenden Gates 14' und 14'' sind zusammen mit dem Gate 14 an einen gemeinsamen Steueranschluss G geführt. Die Kurzschlussgebiete 11' und 11'' der Strukturen M' und M'' sind von einer gemeinsamen leitenden Belegung 15' kontaktiert, die ihre einander zugekehrten pn-Übergänge gegenüber der p-Basisschicht 2 niederohmig überbrückt. Die übrigen Schaltungsteile von Fig. 6 entsprechen den gleichbezeichneten Schaltungsteilen von Fig. 1.

Der Thyristor nach Fig. 6 wird in gleicher Weise betrieben wie der nach Fig. 1, mit dem Unterschied, dass neben einem n-Kanal 19 gleichzeitig weitere n-Kanäle 19' und 19'' wirksam geschaltet werden. Somit sind im blockierten Zustand des Thyristors jeweils drei Strompfade zwischen den Hilfsemitterteilgebieten 9a und 9b und der p-Basisschicht 2 vorhanden, wodurch eine grössere Stabilisierungswirkung als bei dem Thyristor nach Fig. 1 erzielt wird. In dem Zeitraum von t1 bis t2 werden die über die Kanäle 19, 19' und 19'' verlaufenden Strompfade zur Steigerung der Zündempfindlichkeit abgeschaltet.

Der Thyristor nach Fig. 6 hat mit Vorteil einen bezüglich einer Symmetrieachse S rotationssymmetrischen Aufbau, wobei die dargestellten Teilstrukturen jeweils kreisringförmig ausgebildet sind.

Nach einer weiteren Ausgestaltung der Erfindung können sämtliche der in den Figuren 1 und 6 dargestellten Teilstrukturen mit Ausnahme der Basisschichten 2 und 3 und des p-Emitters 4 auch in Form von langgestreckten Streifen ausgebildet sein, deren Längsachsen senkrecht zu den Bildebenen von Fig. 1 und Fig. 6 angeordnet sind. Diese Teilstrukturen erstrecken sich zweckmässigerweise über den gesamten Thyristorquerschnitt.

Bei dieser Ausgestaltung müssen dann gestrichelt gezeichnete Verbindungsleitungen 23 bis 25 zwischen gleichbezeichneten Teilen von Fig. 1 vorgesehen sein. Diese Verbindungsleitungen sind auch in Fig. 6 gestrichelt angedeutet.

Mit Vorteil kann die leitende Belegung 15 und die Zündelektrode 16 als eine gemeinsame Belegung ausgebildet sein, oder die Belegung 15 wird mit dem Anschluss Z verbunden, wobei dann die Elektrode 16 entfällt.

Im Rahmen der Erfindung kann auch ein p-leitendes Hilfsemittergebiet vorgesehen sein, das im Abstand vom p-Emitter in die n-Basisschicht eingefügt ist und mit abschaltbaren Strompfaden der oben beschriebenen Art versehen ist. Zur Erläuterung dieser Schaltungsvariante können die Figuren 1 und 6 dienen, wenn die Bezeichnungen der Anschlüsse A und K miteinander vertauscht werden, die einzelnen Halbleiterteile jeweils die entgegengesetzten Leitungstypen aufweisen und die Ströme und Spannungen jeweils mit umgekehrter Polarität zugeführt werden.

Die Eindringtiefe der Halbleitergebiete 1, 9, 9a, 9b, 11, 11' und 11'' in die P-Basisschicht 2 kann beispielsweise 3 μm betragen. Hierbei kommt dann ein Abstand des Kurzschlussgebietes 11 vom Hilfsemittergebiet 9 von z.B. 5 μm in Betracht. Die lateralen Abmessungen der Kurzschlussgebiete 11, 11' und 11'' in den Bildebenen der Figuren 1 und 6 können beispielsweise jeweils 10 μm betragen. Der Halbleiterkörper des Thyristors nach den Figuren 1 oder 6 weist die Form einer dünnen, insbesondere runden Scheibe mit einer Dicke von z.B. 200 μm bis 1 mm auf.

## Patentansprüche

1. Thyristor mit einem Halbleiterkörper, der einen von einer Kathode (K) kontaktierten n-Emitter (1) mit einer angrenzenden p-Basisschicht (2) und einen von der Anode (A) kontaktierten p-Emitter (4) mit einer angrenzenden n-Basisschicht (3) aufweist, bei dem an der den einen Emitter (1) enthaltenden Grenzfläche (7) des Halbleiterkörpers wenigstens ein als MIS-Struktur (M) ausgebildeter, abschaltbarer Strompfad vorgesehen ist, wobei die an diesen Emitter (1) angrenzende Basisschicht (2) wenigstens teilweise bis an die diesen Emitter (1) enthaltende Grenzfläche (7) des Halbleiterkörpers reicht, wobei der Strompfad ein erstes Halbleitergebiet eines ersten Leitungstyps, das aus einem in die letztgenannte Basisschicht (2) eingefügten und über eine leitende Belegung (15) mit dieser Basisschicht verbundenen Kurzschlussgebiet (11) besteht, ferner ein zweites Halbleitergebiet des ersten Leitungstyps sowie einen zwischen diesen beiden Halbleitergebieten liegenden Halbleiterbereich (12) eines zweiten Leitungstyps umfasst und wobei dieser Halbleiterbereich (12) von einem gegenüber dem Halbleiterkörper elektrisch isolierten, mit einem Steueranschluss (D) versehenen Gate (14) überdeckt ist und aus einem Teilbereich der letztgenannten Basisschicht (2) besteht, dadurch gekennzeichnet, dass an der mit der MIS-Struktur (M) versehenen Grenzfläche (7) des Halbleiterkörpers ein von einer Hilfsemitterelektrode (10) kontaktiertes Hilfsemittergebiet (9) vorgesehen ist, dass das zweite Halbleitergebiet aus einem Randbereich des Hilfsemitters (9) besteht, so dass es mit der Hilfsemitterelektrode (10) niederohmig verbunden ist, und dass einer der Emitter (1) mit einer Anzahl von festen Emitterkurzschlüssen (18) versehen ist.

2. Thyristor nach Anspruch 1, dadurch gekennzeichnet, dass wenigstens eine der MIS-Strukturen (M) dem Verarmungstyp angehört und ein in ihren Halbleiterbereich (12) eingefügtes Kanalgebiet des ersten Leitungstyps aufweist.

3. Thyristor nach Anspruch 1 oder 2, dadurch gekennzeichnet, dass die an das Hilfsemittergebiet (9) angrenzende Basisschicht (2) mit einer Zündelektrode (16) versehen ist, die einen Anschluss (Z) für einen Zündstromkreis aufweist.

4. Thyristor nach einem der Ansprüche 1 bis 3, dadurch gekennzeichnet, dass das Hilfsemittergebiet in Hilfsemitterteilgebiete (9a, 9b) aufgeteilt ist, die mit untereinander leitend verbundenen Teilen (10a, 10b) der Hilfsemitterelektrode versehen sind, und dass an den Hilfsemitterteilgebieten (9a, 9b) jeweils als MIS-Strukturen (M, M′, M′′) ausgebildete abschaltbare Strompfade vorgesehen sind.

5. Thyristor nach Anspruch 3 oder 4, dadurch gekennzeichnet, dass der Anschluss (Z) für den Zündstromkreis über eine Polaritätsumkehrschaltung (20), gegebenenfalls mit pegelverschiebender Funktion, mit einem den Gates (14, 14′, 14′′) der MIS-Strukturen (M, M′, M′′) gemeinsamen Steueranschluss (G) verbunden ist.

**Claims**

1. A thyristor comprising a semiconductor body having an n-emitter (1) contacted by a cathode (K), an adjoining p-base layer (2), a p-emitter (4) contacted by the anode (A), and an adjoining n-base layer (3), in which at least one disconnectible current path in the form of a MIS-structure (M) is arranged at the boundary surface (7) of the semiconductor body which contains the first emitter (1), where the base layer (2) which adjoins this emitter (1) extends, at least in part, to the boundary surface (7) of the semiconductor body which contains this emitter (1), where the current path comprises a first semiconductor zone of a first conductivity type, consisting of a short-circuit zone (11) which is inserted into the said base layer (2) and is connected to this base layer through a conductive coating (15), and further comprises a second semiconductor zone of the first conductivity type, and a semiconductor zone (12) of a second conductivity type which is located between the two said semiconductor zones, and where the semiconductor zone (12) is covered by a gate (14), which is electrically insulated with respect to the semiconductor body and is provided with a control terminal (D), and which semiconductor zone (12) consists of a sub-zone of the said base layer (2), characterised in that an auxiliary emitter zone (9) contacted by an auxiliary emitter electrode (10), is arranged at the boundary surface (7) of the semiconductor body which is provided with the MIS-structure (M); that the second semiconductor zone consists of an edge region of the auxiliary emitter (9) so that it is connected in low ohmic fashion to the auxiliary emitter electrode (10); and that one of the emitters (1) is provided with a number of fixed emitter short-circuits (18).

2. A thyristor as claimed in Claim 1, characterised in that at least one of the MIS-structures (M) is of the depletion type and comprises a channel zone of the first conductivity type which is inserted in its semiconductor zone (12).

3. A thyristor as claimed in Claim 1 or 2, characterised in that the base layer (2), which adjoins the auxiliary emitter zone (9), is provided with a firing electrode (16) which has a terminal (Z) for a firing circuit.

4. A thyristor as claimed in one of Claims 1 to 3, characterised in that the auxiliary emitter zone is divided into auxiliary emitter sub-zones (9a, 9b) which are provided with parts (10a, 10b) of the auxiliary emitter electrode which are conductively connected to one another; and that disconnectible current paths, each in the form of an MIS-structure (M, M′, M′′) are arranged at the auxiliary emitter sub-zones (9a, 9b).

5. A thyristor as claimed in Claim 3 or 4, characterised in that the terminal (Z) for the firing circuit is connected through a polarity reversal circuit (20), which if necessary has a level-shifting function, to a control terminal (G) which is common to the gates (14, 14′, 14′′) of the MIS-structures (M, M′, M′′).

**Revendications**

1. Thyristor comportant un corps semiconducteur, qui possède un émetteur (1) du type n, qui est en contact avec une cathode (K), et une couche de base (2) de type p jouxtant l'émetteur, et un émetteur (4) de type p, qui est en contact avec l'anode (A), et une couche de base (3) de type jouxtant cet émetteur, et dans lequel il est prévu au moins une voie de courant pouvant être interrompue, qui est réalisée sous la forme d'une structure MIS (M), au niveau de la surface limite (7), contenant l'émetteur (1), du corps semiconducteur, et dans lequel la couche de base (2) jouxtant cet émetteur (1) s'étend au moins partiellement jusqu'à la surface limite (7), contenant cet émetteur (1), du corps semiconducteur, et dans lequel la voie de courant inclut une première région semiconductrice possédant un premier type de conductivité, qui est constituée par une région de court-circuit (11) insérée dans la couche de base (2) indiquée en dernier lieu et est reliée à cette couche de base par l'intermédiaire d'une armature conductrice (15), et en outre une seconde région semiconductrice possédant le premier type de conductivité ainsi qu'une région semiconductrice (12) possédant un type de conductivité et située entre ces deux régions semiconductrices, et dans lequel cette région semiconductrice (12) est recouverte par une grille (14) isolée du point de vue électrique par rapport au corps semiconducteur et munie d'une borne de commande (D), et est constituée par une région partielle de couche de base (2) indiquée en dernier lieu, caractérisé par le fait qu'il est prévu, au niveau de la surface limite (7) du corps semiconducteur, munie de la structure MIS (M), une région d'émetteur auxiliaire (9) qui est en contact avec une électrode d'émetteur auxiliaire (10), que la seconde région conductrice est constituée par une région marginale de l'émetteur auxiliaire (9) de telle sorte qu'elle est reliée selon une liaison à faible valeur ohmique à l'électrode d'émetteur auxiliaire (10), et que l'un des émetteurs (1) est équipé d'un certain nombre de courts-circuits d'émetteur fixes (18).

2. Thyristor suivant la revendication 1, caractérisé par le fait qu'au moins l'une des structures MIS (M) est du type à appauvrissement et possède une zone de canal insérée dans sa région semiconductrice (12) et possédant le premier type de conductivité.

3. Thyristor suivant la revendication 1 ou 2, caractérisé par le fait que la couche de base (2), qui jouxte la région d'émetteur auxiliaire (9), est munie d'une électrode d'amorçage (16), qui possède une borne (Z) pour un circuit d'amorçage.

4. Thyristor suivant l'une des revendications 1 à 3, caractérisé par le fait que la région d'émetteur auxiliaire est subdivisée en régions partielles d'émetteur auxiliaire (9a, 9b), qui sont équipées d'éléments (10a, 10b), reliés de façon conductrice entre eux, de l'électrode d'émetteur auxiliaire, et qu'il est prévu des voies de courant pouvant être interrompues, réalisées respectivement sous la forme de structures MIS (M, M', M''), dans les régions partielles d'émetteur auxiliaire (9a, 9b).

5. Thyristor suivant la revendication 3 ou 4, caractérisé par le fait que la borne (Z) prévue pour le circuit d'amorçage est reliée par l'intermédiaire d'un circuit (20) d'inversion de polarité, possédant éventuellement une fonction de décalage de niveau, à une borne de commande (G) commune aux grilles (14, 14', 14'') des structures MIS (M, M', M'').

# FIG 1

# FIG 2

# FIG 3

# FIG 4

# FIG 5

# FIG 6